# EUROPEAN PATENT SPECIFICATION

(11) **EP 3 624 181 B1**
(45) Date of publication and mention of the grant of the patent: **03.07.2024**
(21) Application number: 19196606.8
(22) Date of filing: 11.09.2019
(51) Int. Cl.: H01L 23/10, H01L 23/16, H01L 23/31, H01L 23/498, H01L 25/065

(54) **SEMICONDUCTOR PACKAGE STRUCTURE HAVING A FRAME WITH TRUNCATED CORNERS**
HALBLEITERGEHÄUSESTRUKTUR MIT EINEM RAHMEN MIT ABGESCHNITTENEN ECKEN
STRUCTURE D'EMBALLAGE DE SEMICONDUCTEUR AVEC UN CADRE AVEC DES COINS TRONQUÉS

(30) Priority: 11.09.2018 US 201862729541 P; 08.09.2019 US 201916563919
(43) Date of publication of application: 18.03.2020
(73) Proprietor: MEDIATEK INC., Hsinchu City 30078 (TW)
(72) Inventor: CHANG, Chia-Cheng, Hsinchu City 30078 (TW); LIN, Tzu-Hung, Hsinchu City 30078 (TW); PENG, I-Hsuan, Hsinchu City 30078 (TW); LIN, Yi-Jou, Hsinchu City 30078 (TW)
(74) Representative: Hoefer & Partner Patentanwälte mbB

(56) References cited:
- US-A- 6 020 221
- US-A1- 2007 069 366
- US-A1- 2009 236 730
- US-A1- 2010 276 799
- US-A1- 2018 123 006
- US-A1- 2018 138 127

## Description

### Background

The present invention relates to a semiconductor package structure, and in particular, to a semiconductor package structure with a frame disposed on a top surface of a package substrate therein. More particularly, the present invention relates to a semiconductor package structure according to the pre-characterizing part of claim 1. Such a semiconductor package structure is shown in US 2018/0138127 A1.

US 2009/0236730 A1 discloses a package including a substrate for receiving a semiconductor chip and a reinforcement structure, wherein the corner of the reinforcement structure may have cut out shapes.

US 2010/0276799 A1 discloses that a semiconductor chip package is secured to a printed circuit board by way of a clamp.

US 2007/0069366 A1 discloses that a stiffener is mounted between a substrate and a heat spreader by means of adhesive.

US 2018/0123006 A1 discloses a retracted region at each of the four outer corners of the frame, but the corners are not defined as being triangle-shaped.

A semiconductor package cannot only provide a semiconductor die with protection from environmental contaminants, but it can also provide an electrical connection between the semiconductor die packaged therein and a substrate, such as a printed circuit board (PCB). For instance, a semiconductor die may be enclosed in an encapsulating material, and traces are electrically connected to the semiconductor die and the substrate.

However, a problem with such a semiconductor package is that it is subject to different temperatures during the packaging process. The semiconductor package may be highly stressed due to the different coefficients of thermal expansion (CTEs) of the various substrate and semiconductor die materials. As a result, the semiconductor package may exhibit warping or cracking so that the electrical connection between the semiconductor die and the substrate may be damaged, and the reliability of the semiconductor package may be decreased.

This problem is exacerbated in the case of a relatively large package, for example a package of 50 mm × 50 mm or larger. Therefore, a novel semiconductor package structure is desirable.

### Summary

A semiconductor package structure according to the invention is defined in the independent claim. The dependent claims define preferred embodiments thereof. It is one object of the present disclosure to provide an improved semiconductor package structure with a frame in order to solve the above-mentioned prior art shortcomings or problems.

These and other objectives of the present invention will no doubt become obvious to those of ordinary skill in the art after reading the following detailed description of the preferred embodiments that are illustrated in the various figures and drawings.

### Brief Description of the Drawings

The present invention can be more fully understood by reading the subsequent detailed description and examples with references made to the accompanying drawings, wherein:
Fig. 1 is a cross-sectional view of a semiconductor package structure according to one example not forming part of the claimed invention but useful for understanding;
Fig. 2 is a plan view of an arrangement of holes in a substrate of the semiconductor package structure shown in Fig. 1, and Fig. 1 is a cross-sectional view of the semiconductor package structure along line I-I' of Fig. 2;
Fig. 3 is a cross-sectional view of a semiconductor package structure according to another example not forming part of the claimed invention but useful for understanding;
Fig. 4 is a schematic plan view of a semiconductor package structure according to an embodiment of the disclosure;
Fig. 5 is a schematic, cross-sectional diagram taken along line II-II' in Fig. 4;
Fig. 6 is a schematic plan view of a semiconductor package structure according to yet another example not forming part of the claimed invention but useful for understanding; and
Fig. 7 is a schematic plan view of a semiconductor package structure according to another embodiment of the disclosure.

### Detailed Description

The following description is of the best-contemplated mode of carrying out the invention. This description is made for the purpose of illustrating the general principles of the invention and should not be taken in a limiting sense. The scope of the invention is determined by the appended claims.

The present invention will be described with respect to particular embodiments and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the invention.

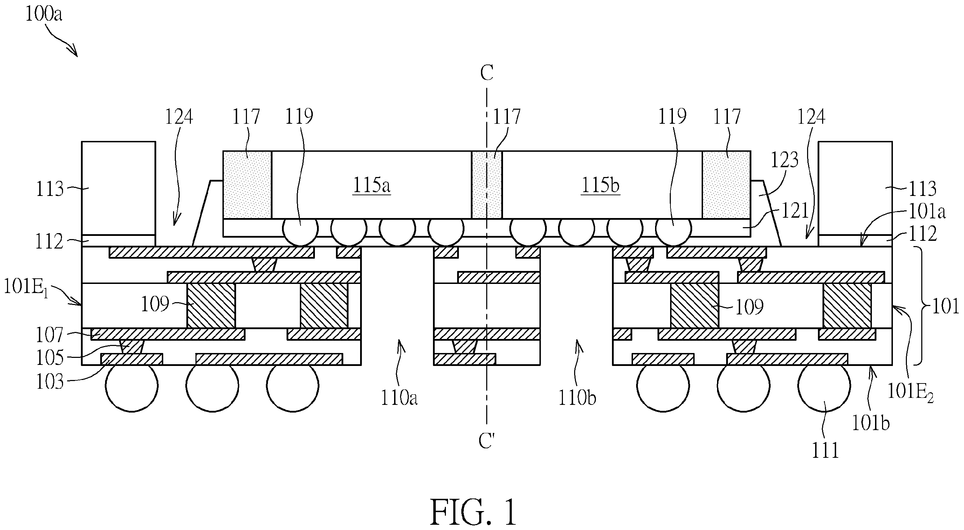

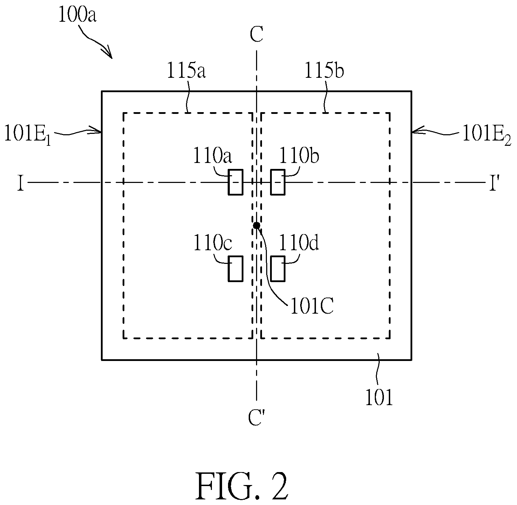

Fig. 1 is a cross-sectional view of a semiconductor package structure 100a according to one example of the disclosure. Fig. 2 is a plan view of an arrangement of holes in a substrate 101 of the semiconductor package structure 100a shown in Fig. 1, and Fig. 1 is a cross-sectional view of the semiconductor package structure 100a along line I-I' of Fig. 2.

Additional features can be added to the semiconductor package structure 100a. Some of the features described below can be replaced or eliminated for different examples and embodiments. To simplify the diagram, only a portion of the semiconductor package structure 100a is depicted in Figs. 1 and 2. Preferably, the semiconductor package structure 100a may include a wafer-level semiconductor package, for example, a flip-chip semiconductor package.

Referring to Fig. 1, the semiconductor package structure 100a may be mounted on a base (not shown). Preferably, the semiconductor package structure 100a may be a system-on-chip (SOC) package structure. Moreover, the base may include a printed circuit board (PCB) and may be formed of polypropylene (PP). Preferably, the base may include a package substrate. The semiconductor package structure 100a may be mounted on the base by a bonding process. For example, the semiconductor package structure 100a may include bump structures 111. Preferably, the bump structures 111 may be conductive ball structures (such as ball grid array (BGA)), conductive pillar structures, or conductive paste structures that are mounted on and electrically coupled to the base by the bonding process.

The semiconductor package structure 100a includes a substrate 101. The substrate 101 has a wiring structure therein. Preferably, the wiring structure in the substrate 101 may be a fan-out structure, and includes one or more conductive pads 103, conductive vias 105, conductive layers 107 and conductive pillars 109. In such cases, the wiring structure in the substrate 101 may be disposed in one or more inter-metal dielectric (IMD) layers. Preferably, the IMD layers may be formed of organic materials, which include a polymer base material, non-organic materials, which include silicon nitride (SiNₓ), silicon oxide (SiOₓ), grapheme, or the like. For example, the IMD layers are made of a polymer base material. It should be noted that the number and configuration of the IMD layers, the conductive pads 103, the conductive vias 105, the conductive layers 107 and the conductive pillars 109 shown in the figures and only some examples and are not limitations to the present invention.

Moreover, the semiconductor package structure 100a further comprises a first semiconductor die 115a and a second semiconductor die 115b bonded onto the substrate 101 through a plurality of conductive structures 119. The substrate 101 has a first surface 101a and a second surface 101b opposite thereto, the first surface 101a is facing the first semiconductor die 115a and the second semiconductor die 115b, and the second surface 101b is facing the above-mentioned base. The conductive structures 119 are disposed over the first surface 101a and below the first semiconductor die 115a and the second semiconductor die 115b, and the bump structures 111 are disposed on the second surface 101b of the substrate 101.

Preferably, the first semiconductor die 115a and the second semiconductor die 115b are electrically coupled to the bump structures 111 through the conductive structures 119 and the wiring structure in the substrate 101. In addition, the conductive structures 119 may be controlled collapse chip connection (C4) structures. It should be noted that the number of semiconductor dies integrated in the semiconductor package structure 100a is not limited to that disclosed in the examples and embodiments, but must be at least two.

Preferably, the first semiconductor die 115a and the second semiconductor die 115b are active devices. For example, the first semiconductor die 115a and the second semiconductor die 115b may be logic dies including a central processing unit (CPU), a graphics processing unit (GPU), a dynamic random access memory (DRAM) controller, or any combinations thereof. Preferably, one or more passive devices are also bonded onto the substrate 101.

The first semiconductor die 115a and the second semiconductor dies 115b are arranged side-by-side. The first semiconductor die 115a and the second semiconductor die 115b are separated by a molding material 117. The molding material 117 surrounds the first semiconductor die 115a and the second semiconductor die 115b, and adjoins the sidewalls of the first semiconductor die 115a and the second semiconductor die 115b. Preferably, the molding material 117 includes a nonconductive material such as an epoxy, a resin, a moldable polymer, or another suitable molding material. Preferably, the molding material 117 is applied as a substantial liquid, and then is cured through a chemical reaction. Preferably, the molding material 117 is an ultraviolet (UV) or thermally cured polymer applied as a gel or malleable solid, and then is cured through a UV or thermal curing process. The molding material 117 may be cured with a mold (not shown).

Preferably, the surfaces of the first semiconductor die 115a and the second semiconductor dies 115b facing away from the first surface 101a of the substrate 101 are exposed by the molding material 117, such that a heat dissipating device (not shown) can directly attached to the surfaces of the first semiconductor die 115a and the second semiconductor dies 115b. As a result, the heat-dissipation efficiency of the semiconductor package structure 100a can be improved, particularly for a large semiconductor package structure, such as 50 mm × 50 mm, which is preferred for high power applications.

The semiconductor package structure 100a may further include a polymer material 121 disposed under the molding material 117, the first semiconductor die 115a and the second semiconductor die 115b, and between the conductive structures 119. The semiconductor package structure 100a may further include an underfill layer 123 interposed between the first surface 101a of the substrate 101 and the polymer material 121. Preferably, the first semiconductor die 115a, the second semiconductor dies 115b and the molding material 117 are surrounded by the underfill layer 123. The polymer material 121 and the underfill layer 123 are disposed to compensate for differing coefficients of thermal expansion (CTEs) between the substrate 101, the conductive structures 119, the first semiconductor die 115a and the second semiconductor dies 115b.

In addition, the semiconductor package structure 100a includes a frame 113 attached to the first surface 101a of the substrate 101 through an adhesive layer 112. The first semiconductor die 115a and the second semiconductor die 115b are surrounded by the frame 113 and the adhesive layer 112. Preferably, the frame 113 and the adhesive layer 112 are separated from the underfill layer 121 by a gap 124. The substrate 101 has a first edge 101E₁ and a second edge 101E₂ opposite thereto. Preferably, the first edge 101 E₁ and the second edge 101E₂ may be coplanar with sidewalls of the frame 113and the adhesive layer 112.

Still referring to Fig. 1, the substrate 101 of the semiconductor package structure 100a includes a first hole 110a and a second hole 110b formed on the second surface 101b. Preferably, at least one of the first hole 110a and the second hole 110b penetrates through the substrate 101 from the first surface 101a to the second surface 101b. Although the first hole 110a and the second hole 110b shown in Fig. 1 penetrate through the substrate 101, in particular, both the first hole 110a and the second hole 110b do not penetrate through the substrate 101 from the first surface 101a to the second surface 101b. Preferably, the first hole 110a is covered by the first semiconductor die 115a, and the second hole 110b is covered by the second semiconductor die 115b. In other words, the first hole 110a is located within the projection of the first semiconductor die 115a on the substrate 101, and the second hole 110b is located within the projection of the second semiconductor die 115b on the substrate 101.

Specifically, the first semiconductor die 115a and the second semiconductor die 115b have a center line C-C' between them. The first hole 110a is disposed closer to the center line C-C' than the first edge 101E₁ of the substrate 101, and the second hole 110b is disposed closer to the center line C-C' than the second edge 101E₂ of the substrate 101. Although there are only two holes in the substrate 101 shown in Fig. 1, it should be noted that there is no limitation on the number of the holes formed in the substrate 101.

Preferably, the first hole 110a and the second hole 110b may be formed by a laser drilling process or another suitable process. It should be noted that the first hole 110a and the second hole 110b may be formed by the same forming process for the conductive pillars 109 in the wiring structure of the substrate 101. Moreover, the first semiconductor die 115a and the second semiconductor die 115b are bonded to the substrate 101 after forming the holes in the substrate 101. Therefore, the damage of the first semiconductor die 115a and the second semiconductor die 115b can be prevented.

Referring to Fig. 2, which is a plan view of an arrangement of holes in a substrate 101 of the semiconductor package structure 100a shown in Fig. 1, and Fig. 1 is a cross-sectional view of the semiconductor package structure 100a along line I-I' of Fig. 2. It should be noted that Fig. 2 is the plan view from the bottom of the semiconductor package structure 100a. In other words, Fig. 2 is the plan view from the second surface 101b of the substrate 101, which the bump structures 111 are disposed on. In particular, the bump structures 111 are omitted for brevity.

As shown in Fig. 2, the substrate 101 may include more than two holes. In particular, the substrate 101 may further include a third hole 110c and the fourth hole 110d formed on the second surface 101b. The third hole 110c is covered by the first semiconductor die 115a, and the fourth hole 110d is covered by the second semiconductor die 115b. It should be noted that the substrate 101 has a center 101C, and the first hole 101a, the second hole 101b, the third hole 110c, and the fourth hole 110d are disposed closer to the center 101C than the first edge 101E₁ and the second edge 101E₂ of the substrate 101.

The holes formed in the substrate 101, for example, the first hole 110a, the second hole 110b, the third hole 110c and the fourth hole 110d, are designed to release the stress in the substrate 101, especially the stress concentrated in the region below the interface between two semiconductor dies (i.e. the first semiconductor die 115a and the second semiconductor die 115b). Since the semiconductor package structure 100a may be highly stressed due to the different coefficients of thermal expansion (CTEs) of the substrate 101 and the semiconductor dies, the holes formed in the substrate 101 can solve the warping or cracking problems caused by mismatched CTEs. As a result, the electrical connection within the semiconductor package structure 100a may not be damaged, and the reliability of the semiconductor package structure 100a may be increased.

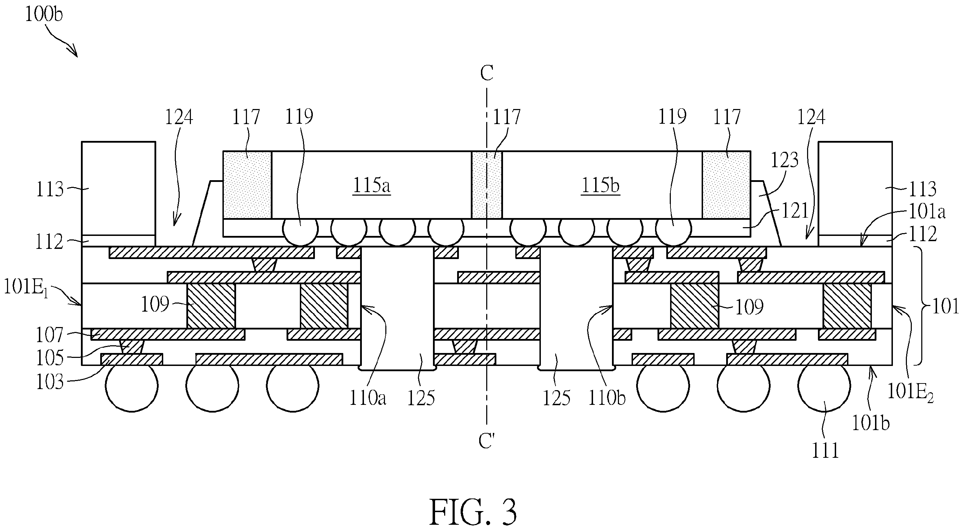

Fig. 3 is a cross-sectional view of a semiconductor package structure 100b according to another example. Descriptions of elements of the examples and embodiments hereinafter that are the same as or similar to those previously described with reference to Fig. 1 are omitted for brevity.

As shown in Fig. 3, the semiconductor package structure 100b includes a stress buffer layer 125 filled in the first hole 110a and the second hole 110b. The stress buffer layer 125 is made of a polymer material, such as a silicone resin or rubber. Preferably, the stress buffer layer 125 is made of an organic resin, such as Ajinomoto Build-up Film (ABF).

Moreover, the stress buffer layer 125 may be formed by a spin coating process. In particular, a material of the stress buffer layer 125 may be dispensed in the first hole 110a and the second hole 110b, and an excess portion of the material of the stress buffer layer 125 may be removed. Preferably, the stress buffer layer 125 may be formed before bonding the first semiconductor die 115a and the second semiconductor die 115b to the substrate 101.

Preferably, the stress buffer layer 125 may filled up the first hole 110a and the second hole 110b, and the surfaces of the stress buffer layer 125 are level with the second surface 101b of the substrate 101. In particular, the surfaces of the stress buffer layer 125 may not be level with the second surface 101b of the substrate 101 according to the actual manufacturing processes.

Filling the first hole 110a and the second hole 110b with the stress buffer layer 125 may offer advantages like preventing the impurities and dusts from dropping into the first hole 110a and the second hole 110b during the handling process of the substrate 101. In addition, the warping or cracking problems caused by mismatched coefficients of thermal expansion in the semiconductor package structure 100b can be solved by the holes (including the first hole 110a and the second hole 110b) and the stress buffer layer 125 formed in the substrate 101. Accordingly, the electrical connection within the semiconductor package structure 100b may not be damaged, and the lifespan of the semiconductor package structure 100b may be increased.

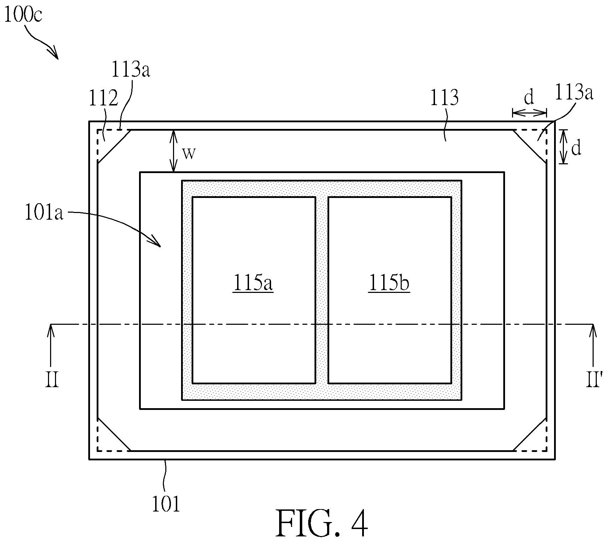

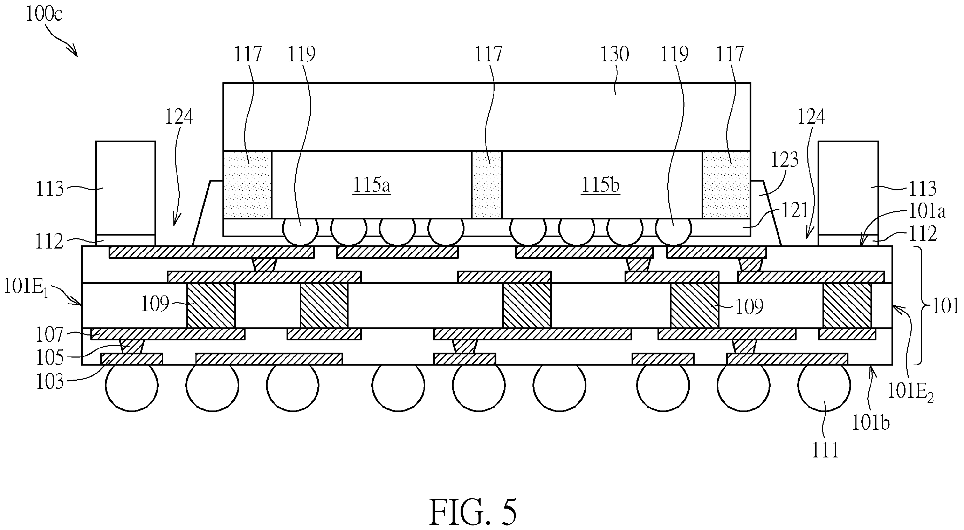

Please refer to Fig. 4 and Fig. 5. Fig. 4 is a schematic plan view of a semiconductor package structure 100c according to an embodiment of the disclosure. Fig. 5 is a schematic, cross-sectional diagram taken along line II-II' in Fig. 4. Like layers, regions or elements are designated by like numeral numbers.

As shown in FIG. 4 and FIG. 5, likewise, the semiconductor package structure 100c comprises a first semiconductor die 115a and a second semiconductor die 115b mounted on the substrate 101 through a plurality of conductive structures 119. The substrate 101 has a first surface 101a and a second surface 101b opposite thereto, the first surface 101a is facing the first semiconductor die 115a and the second semiconductor die 115b, and the second surface 101b is facing the above-mentioned base such as a PCB or a system board. The conductive structures 119 are disposed over the first surface 101a and below the first semiconductor die 115a and the second semiconductor die 115b, and the bump structures 111 are disposed on the second surface 101b of the substrate 101. The bump structures 111 may be a ball grid array (BGA) or a land grid array (LGA). According to one embodiment, a heat sink 130 may be mounted on the first semiconductor die 115a and the second semiconductor die 115b for heat dissipation.

According to the embodiments, the semiconductor package structure 100c comprises a continuous, frame 113 mounted on the first surface 101a of the substrate 101. The frame may be annular. According to one embodiment, the frame 113 may have a substantially rectangular shape when viewed from the above. According to one embodiment, the frame 113 may be made of metal or metal alloys. For example, the frame 113 may be made of copper, but is not limited thereto. The frame 113 may be attached to the first surface 101a of the substrate 101 through the adhesive layer 112. According to an example not forming part of the claimed invention, the frame 113 has four bevel angles at its four corners, instead of the four right-angle corners as depicted in FIG. 2. Portions of the frame within the retracted regions 113a, which are indicated by dashed lines, may be truncated from the frame 113 by any suitable cutting means to form the bevel angles at the four corners of the frame 113.

In a case that the bump structures 111 are LGA arrangement, a securing means such as a socket (not shown) may be provided on the frame 113 to secure the substrate 101 to the aforesaid base such as a PCB or a system board. The socket may exert undesired mechanical stress onto the frame 113 and the substrate 101 and may cause damage or defects such as fractures in the substrate 101. To alleviate such stress caused by the socket, a frame 113 with a wider width w is desired. However, the frame with a wider width makes the warpage problem worse. The present disclosure solves the warpage problem by truncating the corners of the frame 113, thereby eliminating or reducing the warpage when a frame with wider width is used.

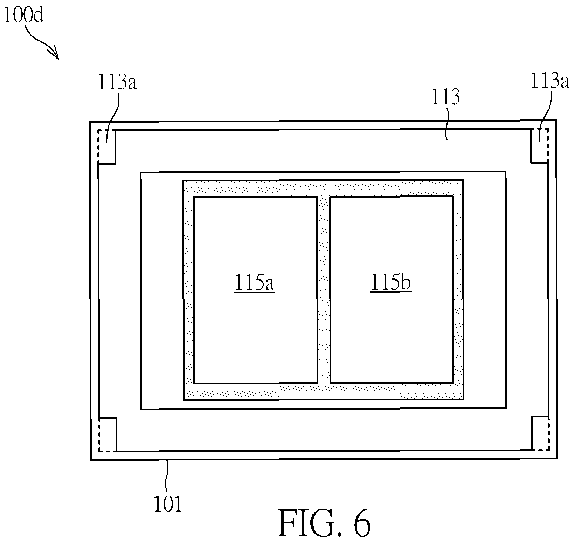

According to the embodiments, each of the retracted regions 113a is of a right-triangle shape. In examples not forming part of the claimed invention, each of the retracted regions 113a may be of a rectangular shape, as the semiconductor package structure 100d depicted in FIG. 6. It is understood that the shapes of the truncated edge at the four corners of the frame 113 in FIG. 6 are for illustration purposes only. In examples, the shapes of the truncated edge may comprise arc shapes, curved shapes or irregular shapes and the cut shape at the four corners of the frame 113 may depend upon design requirements in order to obtain improvement on package warpage, stress distribution and cost, but the embodiments are limited to right-triangle shapes as set out in claim 1. According to one embodiment, the adhesive layer 112 within the retracted regions 113a may be exposed after the truncated frame 113 is mounted on the first surface 101a of the substrate 101.

The frame 113 has a width w, which may range between 1 mm and 18 mm, for example, 12 mm. Preferably, the width w of the frame 113 may be greater than or equal to 1 mm. In particular, the area of each of the right-triangle shaped retracted regions 113a is presented by d²/2, wherein d is the length of the sides or legs of the right-triangle shaped retracted regions 113a. The length d is greater than or equal to w/2. By providing such right-triangle shaped retracted regions 113a in the frame 113 and optionally in the adhesive layer 112, the warpage control of the semiconductor package structure 100c can be significantly improved.

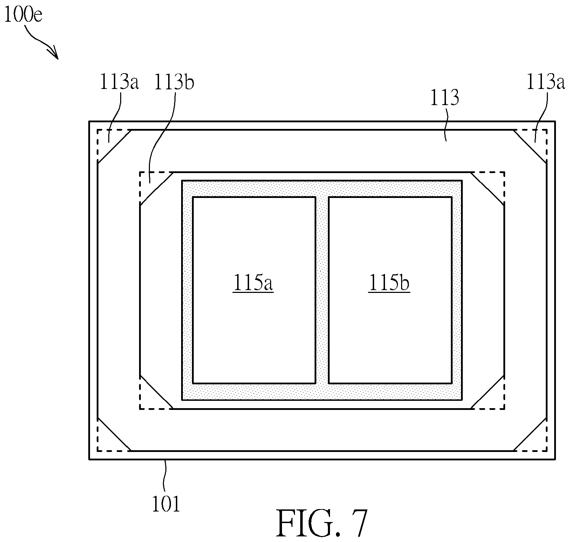

Fig. 7 is a schematic plan view of a semiconductor package structure 100e according to yet another embodiment of the disclosure. As shown in Fig. 7, the difference between the semiconductor package structure 100e in Fig. 7 and the semiconductor package structure 100c in Fig. 4 is that the frame 113 of the semiconductor package structure 100e in Fig. 7 comprises an extension portion 113b that inwardly extends at the inner corners of the frame 113. Therefore, the inner corners of the frame 113 comprise no right angle. By providing such configuration, the removed right-triangle shaped retracted regions 113a at the outer corners of the frame 113 may be compensated by adding the extension portions 113b at the inner corners of the frame 113, which are indicated by dashed lines. It is beneficial to do so because the overall surface of the frame 113 for mounting the socket may be maintained and the stress exerted by the socket or the securing means of the socket may be more evenly distributed across the frame 113.

Those skilled in the art will readily observe that numerous modifications and alterations of the device and method may be made. Accordingly, the above disclosure should be construed as limited only by the appended claims.

## Claims

1. A semiconductor package structure (100c, 100e), comprising:
a substrate (101) having a first surface (101a) and second surface (101b) opposite thereto, wherein the substrate (101) comprises a wiring structure (103, 105, 107, 109);
a first semiconductor die (115a) disposed on the first surface (101a) of the substrate (101) and electrically coupled to the wiring structure (103, 105, 107, 109);
a second semiconductor die (115b) disposed on the first surface (101a) and electrically coupled to the wiring structure (103, 105, 107, 109), wherein the first semiconductor die (115a) and the second semiconductor die (115b) are arranged in a side-by-side manner;
a molding material (117) surrounding the first semiconductor die (115a) and the second semiconductor die (115b), wherein the first semiconductor die (115a) is separated from the second semiconductor die (115b) by the molding material (117); and
a frame (113) mounted on the first surface (101a) of the substrate (101), wherein the frame (113) surrounds the first semiconductor die (115a) and the second semiconductor die (115b);
**characterized in that**
the frame (113) comprises a retracted region (113a) at each of the four outer corners of the frame (113), each retracted region (113a) has a right-triangle shape and the area of each right-triangle shaped retracted region (113a) is presented by d²/2, wherein d is the length of the sides of legs of the right-triangle shaped retracted region (113a), d is greater than or equal to w/2 and w is the width of the frame (113).

2. The semiconductor package structure (100c, 100e) according to any one of the preceding claims further comprising bump structures (111) disposed on the second surface (101b) of the substrate (101).

3. The semiconductor package structure (100c, 100e) according to claim 2, wherein the bump structures (111) are a land grid array, in the following also referred to as LGA, wherein preferably a securing means is provided on the frame (113) to secure the substrate (101) to a base.

4. The semiconductor package structure (100c, 100e) according to claim 3, wherein the base comprises a PCB or a system board.

5. The semiconductor package structure (100c, 100e) according to claim 3 or 4, wherein the securing means comprises a socket.

6. The semiconductor package structure (100e) according to claim 5 further comprising respective extension portions (113b) that inwardly extend at respective ones of the four inner corners of the frame (113).

7. The semiconductor package structure (100c, 100e) according to any one of the preceding claims further comprising an adhesive layer (112) between the frame (113) and the first surface (101a) of the substrate (101).

8. The semiconductor package structure (100c, 100e) according to claim 7, wherein the adhesive layer (112) also covers the first surface (101a) of the substrate (101) within the retracted regions (113a).

9. The semiconductor package structure (100c, 100e) according to any one of the preceding claims, wherein the width w of the frame (113) is greater than or equal to 1 mm and/or ranges between 1 mm and 18 mm.

## Patentansprüche

1. Halbleitergehäusestruktur (100c, 100e), aufweisend:
ein Substrat (101), das eine erste Oberfläche (101a) und eine zweite Oberfläche (101b) gegenüber davon aufweist, wobei das Substrat (101) eine Verdrahtungsstruktur (103, 105, 107, 109) aufweist;
einen ersten Halbleiter-Die (115a), der auf der ersten Oberfläche (101a) des Substrats (101) angeordnet und elektrisch mit der Verdrahtungsstruktur (103, 105, 107, 109) verbunden ist;
einen zweiten Halbleiter-Die (115b), der auf der ersten Oberfläche (101a) angeordnet und elektrisch mit der Verdrahtungsstruktur (103, 105, 107, 109) verbunden ist, wobei der erste Halbleiter-Die (115a) und der zweite Halbleiter-Die (115b) nebeneinander angeordnet sind;
ein Gussmaterial (117), das den ersten Halbleiter-Die (115a) und den zweiten Halbleiter-Die (115b) umgibt, wobei der erste Halbleiter-Die (115a) durch das Gussmaterial (117) von dem zweiten Halbleiter-Die (115b) getrennt ist; und
einen Rahmen (113), der auf der ersten Oberfläche (101a) des Substrats (101) angebracht ist, wobei der Rahmen (113) den ersten Halbleiter-Die (115a) und den zweiten Halbleiter-Die (115b) umgibt;
**dadurch gekennzeichnet, dass**
der Rahmen (113) einen zurückgenommenen Bereich (113a) an jeder der vier äußeren Ecken des Rahmens (113) aufweist, jeder zurückgenommene Bereich (113a) eine Form eines rechtwinkligen Dreiecks aufweist und die Fläche jedes der zurückgenommenen Bereiche (113a) mit der Form eines rechtwinkligen Dreiecks durch d²/2 repräsentiert wird, wobei d die Länge der Seiten von Schenkeln des zurückgenommenen Bereichs (113a) mit der Form des rechtwinkligen Dreiecks ist, d größer oder gleich w/2 ist, und w die Breite des Rahmens (113) ist.

2. Halbleitergehäusestruktur (100c, 100e) gemäß einem der vorstehenden Ansprüche, die weiter Bump-Strukturen (111) aufweist, die auf der zweiten Oberfläche (101b) des Substrats (101) angeordnet sind.

3. Halbleitergehäusestruktur (100c, 100e) gemäß Anspruch 2, wobei die Bump-Strukturen (111) ein Land Grid Array, im Folgenden auch als LGA bezeichnet, sind, wobei vorzugsweise eine Sicherungseinrichtung auf dem Rahmen (113) vorgesehen ist, um das Substrat (101) an einer Basis zu sichern.

4. Halbleitergehäusestruktur (100c, 100e) gemäß Anspruch 3, wobei die Basis ein PCB oder eine Systemplatine umfasst.

5. Halbleitergehäusestruktur (100c, 100e) gemäß Anspruch 3 oder 4, wobei die Sicherungseinrichtung einen Sockel umfasst.

6. Halbleitergehäusestruktur (100e) gemäß Anspruch 5, die weiter jeweilige Erweiterungsteile (113b) aufweist, die jeweilige der vier inneren Ecken des Rahmens (113) nach innen erweitern.

7. Halbleitergehäusestruktur (100c, 100e) gemäß einem der vorstehenden Ansprüche, die weiter eine Haftschicht (112) zwischen dem Rahmen (113) und der ersten Oberfläche (101a) des Substrats (101) aufweist.

8. Halbleitergehäusestruktur (100c, 100e) gemäß Anspruch 7, wobei die Haftschicht (112) auch die erste Oberfläche (101a) des Substrats (101) innerhalb der zurückgenommenen Bereiche (113a) bedeckt.

9. Halbleitergehäusestruktur (100c, 100e) gemäß einem der vorstehenden Ansprüche, wobei die Breite w des Rahmens (113) größer oder gleich 1 mm ist und/oder von 1 mm bis 18 mm reicht.

## Revendications

1. Structure de boîtier de semi-conducteur (100c, 100e), comprenant :
un substrat (101) ayant une première surface (101a) et une seconde surface (101b) opposée à celle-ci, où le substrat (101) comprend une structure de câblage (103, 105, 107, 109) ;
une première puce semi-conductrice (115a) disposée sur la première surface (101a) du substrat (101) et couplée électriquement à la structure de câblage (103, 105, 107, 109) ;
une seconde puce semi-conductrice (115b) disposée sur la première surface (101a) et couplée électriquement à la structure de câblage (103, 105, 107, 109), où la première puce semi-conductrice (115a) et la seconde puce semi-conductrice (115b) sont agencées côte à côte ;
un matériau de moulage (117) entourant la première puce semi-conductrice (115a) et la seconde puce semi-conductrice (115b), où la première puce semi-conductrice (115a) est séparée de la seconde puce semi-conductrice (115b) par le matériau de moulage (117) ; et
un cadre (113) monté sur la première surface (101a) du substrat (101), où le cadre (113) entoure la première puce semi-conductrice (115a) et la seconde puce semi-conductrice (115b) ;
**caractérisée en ce que**
le cadre (113) comprend une région rétractée (113a) à chacun des quatre coins externes du cadre (113), chaque région rétractée (113a) a une forme de triangle rectangle et la superficie de chaque région rétractée en forme de triangle rectangle (113a) est présentée par d²/2, où d est la longueur des côtés de pattes de la région rétractée en forme de triangle rectangle (113a), d est supérieure ou égale à w/2 et w est la largeur du cadre (113).

2. Structure de boîtier de semi-conducteur (100c, 100e) selon l'une quelconque des revendications précédentes comprenant en outre des structures à bosses (111) disposées sur la seconde surface (101b) du substrat (101).

3. Structure de boîtier de semi-conducteur (100c, 100e) selon la revendication 2, dans laquelle les structures à bosses (111) sont un boîtier matriciel à plots, également appelé dans ce qui suit LGA, où de préférence un moyen de fixation est prévu sur le cadre (113) pour fixer le substrat (101) à une base.

4. Structure de boîtier de semi-conducteur (100c, 100e) selon la revendication 3, dans laquelle la base comprend une carte PCB ou une carte système.

5. Structure de boîtier de semi-conducteur (100c, 100e) selon la revendication 3 ou 4, dans laquelle le moyen de fixation comprend une douille.

6. Structure de boîtier de semi-conducteur (100e) selon la revendication 5, comprenant en outre des parties d'extension respectives (113b) qui s'étendent vers l'intérieur à des coins respectifs des quatre coins internes du cadre (113).

7. Structure de boîtier de semi-conducteur (100c, 100e) selon l'une quelconque des revendications précédentes comprenant en outre une couche adhésive (112) entre le cadre (113) et la première surface (101a) du substrat (101).

8. Structure de boîtier de semi-conducteur (100c, 100e) selon la revendication 7, dans laquelle la couche adhésive (112) recouvre également la première surface (101a) du substrat (101) à l'intérieur des régions rétractées (113a).

9. Structure de boîtier de semi-conducteur (100c, 100e) selon l'une quelconque des revendications précédentes, dans laquelle la largeur w du cadre (113) est supérieure ou égale à 1 mm et/ou se trouve dans la plage allant de 1 mm à 18 mm.
